# EUROPEAN PATENT APPLICATION

(11) **EP 3 462 516 A1**
(43) Date of publication of application: **03.04.2019**
(21) Application number: 17194347.5
(22) Date of filing: 02.10.2017
(51) Int. Cl.: H01L 51/54

(54) **ELECTRONIC DEVICE AND METHOD FOR PREPARING THE SAME**

(71) Applicant: Novaled GmbH, 01307 Dresden (DE)
(72) Inventor: Hummert, Markus, 01307 Dresden (DE); Rosenow, Thomas, 01307 Dresden (DE)
(74) Representative: Bittner, Thomas L.

(57) **Abstract**

The present invention relates to an electronic device comprising, between a first electrode (120) and a second electrode (190), at least one hole injection layer (130) and/or at least one hole generating layer (135), wherein the hole injection layer and/or the hole generating layer consists of a bismuth carboxylate complex, and a to a method for preparing the same.

## Description

The present invention relates to an electronic device and a method for preparing the same.

### BACKGROUND ART

Organic light-emitting diodes (OLEDs), which are self-emitting devices, have a wide viewing angle, excellent contrast, quick response, high brightness, excellent driving voltage characteristics, and color reproduction. A typical OLED includes an anode, a hole transport layer (HTL), an emission layer (EML), an electron transport layer (ETL), and a cathode, which are sequentially stacked on a substrate. In this regard, the HTL, the EML, and the ETL are thin films formed from organic and / or organometallic compounds.

When a voltage is applied to the anode and the cathode, holes injected from the anode electrode move to the EML, via the HTL, and electrons injected from the cathode electrode move to the EML, via the ETL. The holes and electrons recombine in the EML to generate excitons. When the excitons drop from an excited state to a ground state, light is emitted. The injection and flow of holes and electrons should be balanced, so that an OLED having the above-described structure has excellent efficiency.

WO2016/050330 A1 and WO2016/062368 disclose organic electronic devices. In the devices Bi-carboxylate complexes are used as p-dopants. The p-dopants are mixed with an organic hole transport matrix material.

However, the devices disclosed in the prior art suffer from high operational voltage and unsatisfactory efficiency.

It is, therefore, the object of the present invention to provide an electronic device and a method for preparing the same overcoming drawbacks of the prior art, in particular to provide electronic devices comprising an organic hole transport material, the electronic devices having improved performance, in particular reduced operational voltage and/or improved efficiency, in particular in OLEDs.

### DESCRIPTION OF THE INVENTION

The above object is achieved by an electronic device comprising, between a first electrode and a second electrode, at least one hole injection layer and/or at least one hole generating layer, wherein the hole injection layer and/or the hole generating layer consists of a bismuth carboxylate complex. Surprisingly, it was found by the present inventors that a device comprising a bismuth carboxylate complex as a neat layer said layer being a hole injection layer and/or a hole generating layer - performs significantly better than an analogous device comprising the same Bi-carboxylate complex mixed with an organic matrix material.

The bismuth carboxylate may be electrically neutral. In this way, easy handling during preparation of the electronic device, in particular during vacuum thermal evaporation (VTE), may be achieved.

The bismuth carboxylate complex may be mononuclear. Respective mononuclear complexes show favourable volatility range during preparation of the inventive electronic devices.

The bismuth in the bismuth carboxylate complex may be in the oxidation state +III. Using respective bismuth carboxylate complexes in the oxidation state +III is favourable for device performance.

The bismuth carboxylate complex may comprise a carboxylate anion which is partially or fully fluorinated and/or which comprises at least one nitrile group. Using respectively substituted carboxylate anions may result in beneficial electronic states of the inventive hole injection/hole generating layers.

The bismuth carboxylate complex may comprise at least one aromatic ring and/or at least one heteroaromatic ring. The respective choice of aromatic/heteroaromatic carboxylates may result in beneficial electronic states of the inventive bismuth carboxylate complex and may enable tuning the processing properties (such as volatility and/or solubility) thereof.

The bismuth carboxylate complex may be represented by the following formula (I) 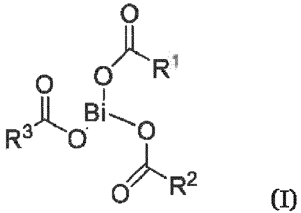 wherein R¹, R² and R³ are independently selected from a group comprising 1 to 40 carbon atoms, alternatively 2 to 30 carbon atoms, alternatively 3 to 20 carbon atoms, alternatively 4 to 16 carbon atoms, alternatively 5 to 12 carbon atoms, wherein (i) each of the R¹, R², R³ may independently be substituted with one or more halogen atom(s) and/or one or more nitrile group(s) and/or (ii) two or more of the groups R¹, R² and R³ may be linked with each other to form a ring. Using the bismuth carboxylate complexes of Formula (I) in hole injection and/or hole generation layers, favourable operational voltage may be achieved in devices comprising such layers.

At least two of R¹, R² and R³ may be the same, alternatively all of R¹, R² and R³ may be the same. The latter embodiment may be advantageous particularly from the viewpoint of easy synthetic accessibility of such compounds.

At least one of R¹, R² and R³ may comprise at least one trifluoromethyl group. The use of a trifluoromethyl group in the carboxylate groups of the bismuth carboxylate complex may be suitable for adjusting electronic states of the bismuth carboxylate complex.

At least one of R¹, R² and R³ may be a phenyl group substituted with at least one trifluoromethyl groups and/or substituted with at least one nitrile group. Besides adjusting electronic states/energy levels in the respective compounds, the trifluoromethyl/nitrile substitution in phenyl groups may represent a suitable means for adjusting processing properties.

At least of one R¹, R² and R³ may be a bis(trifluoromethyl)phenyl. These compounds were found to be particularly suitable to improve the device performance.

At least one of R¹, R² and R³ may be a 3,5-Bis(trifluoromethyl)phenyl. These compounds are particularly suitable to improve the device performance.

The bismuth carboxylate complex may have the following chemical formula

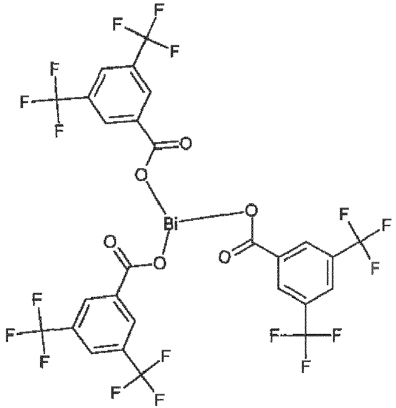

Best results with respect to the inventive electronic device performance were achieved using such complexes.

The electronic device may further comprise a hole transport layer in direct contact with the hole injection and/or hole generating layer consisting of the bismuth carboxylate complex. In such arrangement of the electronic device, surprisingly good device performance may be achieved with simple hole transport layers consisting of an undoped hole transport matrix material.

The object is further achieved by a method for preparing the inventive device comprising the steps of (i) evaporating the bismuth carboxylate complex to form a vapor; and (ii) depositing the vapor on a solid support to form the hole injection layer and/or the hole generating layer. State-of-art devices comprising hole injection layers doped with a bismuth carboxylate complex require processes comprising the step of codeposition of two components, which may be unfavourable from the viewpoint of process reproducibility and/or may bring undesired limitations in material selection. In comparison with these processes, the inventive process is robust and offers an additional degree of freedom in selection of the bismuth carboxylate complex as well as in selection of the material for the adjacent hole transport layer.

The evaporating in step (i) may be carried out at elevated temperatures and/or reduced pressure. This embodiment may be advantageous for adjusting the processing conditions to processing properties of chosen materials.

The solid support may be a previously deposited layer. In particular, the solid support may be the anode, an electron generating layer, and/or an interlayer deposited on top of the electron generating layer.

The method may comprise a further step of forming a hole transport layer on top of the hole injection layer and/or the hole generating layer formed in step (ii). In this way, an inventive electronic device having improved performance can be prepared with reduced efforts.

### Further layers

In accordance with the invention, the electronic device may comprise, besides the layers already mentioned above, further layers. Exemplary embodiments of respective layers are described in the following:

### Substrate

The substrate may be any substrate that is commonly used in manufacturing of, electronic devices, such as organic light-emitting diodes. If light is to be emitted through the substrate, the substrate shall be a transparent or semitransparent material, for example a glass substrate or a transparent plastic substrate. If light is to be emitted through the top surface, the substrate may be both a transparent as well as a non-transparent material, for example a glass substrate, a plastic substrate, a metal substrate or a silicon substrate.

### Anode electrode

Either the first electrode or the second electrode may be an anode electrode. The anode electrode may be formed by depositing or sputtering a material that is used to form the anode electrode. The material used to form the anode electrode may be a high work-function material, so as to facilitate hole injection. The anode material may also be selected from a low work function material (i.e. aluminum). The anode electrode may be a transparent or reflective electrode. Transparent conductive oxides, such as indium tin oxide (ITO), indium zinc oxide (IZO), tin-dioxide (SnO2), aluminum zinc oxide (AlZO) and zinc oxide (ZnO), may be used to form the anode electrode. The anode electrode may also be formed using metals, typically silver (Ag), gold (Au), or metal alloys.

### Hole injection layer

In accordance with the invention, the hole injection layer may consist of the bismuth carboxylate complex. However, the present invention relates also to embodiments wherein the electronic device comprises both a hole injection layer and a hole generating layer. In this case, it is possible that only the hole generating layer consists of the bismuth carboxylate complex. In such embodiment, the material of the hole injection layer may be an alternative material as described below. The hole injection layer (HIL) may be formed on the anode electrode by vacuum deposition, spin coating, printing, casting, slot-die coating, Langmuir-Blodgett (LB) deposition, or the like. When the HIL is formed using vacuum deposition, the deposition conditions may vary according to the compound that is used to form the HIL, and the desired structure and thermal properties of the HIL. In general, however, conditions for vacuum deposition may include a deposition temperature of 100° C to 500° C, a pressure of 10⁻⁸ to 10⁻³ Torr (1 Torr equals 133.322 Pa), and a deposition rate of 0.1 to 10 nm/sec.

When the HIL is formed using spin coating or printing, coating conditions may vary according to the compound that is used to form the HIL, and the desired structure and thermal properties of the HIL. For example, the coating conditions may include a coating speed of about 2000 rpm to about 5000 rpm, and a thermal treatment temperature of about 80° C to about 200° C. Thermal treatment removes a solvent after the coating is performed.

The HIL may be formed - if the electronic device comprises besides the hole injection layer a hole generating layer and the hole generating layer consists of the bismuth carboxylate complex - of any compound that is commonly used to form a HIL. Examples of compounds that may be used to form the HIL include a phthalocyanine compound, such as copper phthalocyanine (CuPc), 4,4',4"-tris (3-methylphenylphenylamino) triphenylamine (m-MTDATA), TDATA, 2T-NATA, polyaniline/dodecylbenzenesulfonic acid (Pani/DBSA), poly(3,4-ethylenedioxythiophene)/poly(4-styrenesulfonate) (PEDOT/PSS), polyaniline/camphor sulfonic acid (Pani/CSA), and polyaniline)/poly(4-styrenesulfonate (PANI/PSS).

In such a case, the HIL may be a pure layer of p-dopant or may be selected from a hole-transporting matrix compound doped with a p-dopant. Typical examples of known redox doped hole transport materials are: copper phthalocyanine (CuPc), which HOMO level is approximately -5.2 eV, doped with tetrafluoro-tetracyanoquinonedimethane (F4TCNQ), which LUMO level is about -5.2 eV; zinc phthalocyanine (ZnPc) (HOMO = - 5.2 eV) doped with F4TCNQ; α-NPD (N,N'-Bis(naphthalen-1-yl)-N,N'-bis(phenyl)-benzidine) doped with F4TCNQ. α-NPD doped with 2,2'-(perfluoronaphthalen-2,6-diylidene) dimalononitrile (PD1). α-NPD doped with 2,2',2"-(cyclopropane-1,2,3-triylidene)tris(2-(p-cyanotetrafluorophenyl)acetonitrile) (PD2). Dopant concentrations can be selected from 1 to 20 wt.-%, more preferably from 3 wt.-% to 10 wt.-%.

The thickness of the HIL may be in the range from about 1 nm to about 100 nm, and for example, from about 1 nm to about 25 nm. When the thickness of the HIL is within this range, the HIL may have excellent hole injecting characteristics, without a substantial penalty in driving voltage.

### Hole transport layer

The hole transport layer (HTL) may be formed on the HIL by vacuum deposition, spin coating, slot-die coating, printing, casting, Langmuir-Blodgett (LB) deposition, or the like. When the HTL is formed by vacuum deposition or spin coating, the conditions for deposition and coating may be similar to those for the formation of the HIL. However, the conditions for the vacuum or solution deposition may vary, according to the compound that is used to form the HTL.

The HTL may be formed of any compound that is commonly used to form a HTL. Compounds that can be suitably used are disclosed for example in Yasuhiko Shirota and Hiroshi Kageyama, Chem. Rev. 2007, 107, 953-1010 and incorporated by reference. Examples of the compound that may be used to form the HTL are: carbazole derivatives, such as N-phenylcarbazole or polyvinylcarbazole; benzidine derivatives, such as N,N'-bis(3-methylphenyl)-N,N'-diphenyl-[1,1-biphenyl]-4,4'-diamine (TPD), or N,N'-di(naphthalen-1-yl)-N,N'-diphenyl benzidine (alpha-NPD); and triphenylamine-based compound, such as 4,4',4"-tris(N-carbazolyl)triphenylamine (TCTA). Among these compounds, TCTA can transport holes and inhibit excitons from being diffused into the EML.

The thickness of the HTL may be in the range of about 5 nm to about 250 nm, preferably, about 10 nm to about 200 nm, further about 20 nm to about 190 nm, further about 40 nm to about 180 nm, further about 60 nm to about 170 nm, further about 80 nm to about 160 nm, further about 100 nm to about 160 nm, further about 120 nm to about 140 nm. A preferred thickness of the HTL may be 170 nm to 200 nm.

When the thickness of the HTL is within this range, the HTL may have excellent hole transporting characteristics, without a substantial penalty in driving voltage.

### Electron blocking layer

The function of the electron blocking layer (EBL) is to prevent electrons from being transferred from the emission layer to the hole transport layer and thereby confine electrons to the emission layer. Thereby, efficiency, operating voltage and/or lifetime are improved. Typically, the electron blocking layer comprises a triarylamine compound. The triarylamine compound may have a LUMO level closer to vacuum level than the LUMO level of the hole transport layer. The electron blocking layer may have a HOMO level that is further away from vacuum level compared to the HOMO level of the hole transport layer. The thickness of the electron blocking layer may be selected between 2 and 20 nm.

The electron blocking layer may comprise a compound of formula Z below (Z).

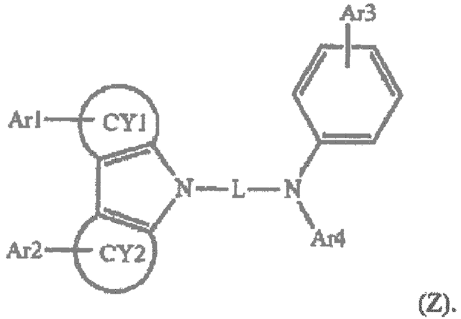

In Formula Z, CY1 and CY2 are the same as or different from each other, and each independently represent a benzene cycle or a naphthalene cycle, Ar1 to Ar3 are the same as or different from each other, and each independently selected from the group consisting of hydrogen; a substituted or unsubstituted aryl group having 6 to 30 carbon atoms; and a substituted or unsubstituted heteroaryl group having 5 to 30 carbon atoms, Ar4 is selected from the group consisting of a substituted or unsubstituted phenyl group, a substituted or unsubstituted biphenyl group, a substituted or unsubstituted terphenyl group, a substituted or unsubstituted triphenylene group, and a substituted or unsubstituted heteroaryl group having 5 to 30 carbon atoms, L is a substituted or unsubstituted arylene group having 6 to 30 carbon atoms.

If the electron blocking layer has a high triplet level, it may also be described as triplet control layer.

The function of the triplet control layer is to reduce quenching of triplets if a phosphorescent green or blue emission layer is used. Thereby, higher efficiency of light emission from a phosphorescent emission layer can be achieved. The triplet control layer is selected from triarylamine compounds with a triplet level above the triplet level of the phosphorescent emitter in the adjacent emission layer. Suitable compounds for the triplet control layer, in particular the triarylamine compounds, are described in EP 2 722 908 A1.

### Emission layer (EML)

The EML may be formed on the HTL by vacuum deposition, spin coating, slot-die coating, printing, casting, LB deposition, or the like. When the EML is formed using vacuum deposition or spin coating, the conditions for deposition and coating may be similar to those for the formation of the HIL. However, the conditions for deposition and coating may vary, according to the compound that is used to form the EML.

The emission layer (EML) may be formed of a combination of a host and an emitter dopant. Example of the host are Alq3, 4,4'-N,N'-dicarbazole-biphenyl (CBP), poly(n-vinylcarbazole) (PVK), 9,10-di(naphthalene-2-yl)anthracene (ADN), 4,4',4"-tris(carbazol-9-yl)-triphenylamine(TCTA), 1,3,5-tris(N-phenylbenzimidazole-2-yl)benzene (TPBI), 3-tert-butyl-9,10-di-2-naphthylanthracenee (TBADN), distyrylarylene (DSA), bis(2-(2-hydroxyphenyl)benzo-thiazolate)zinc (Zn(BTZ)₂), G3 below, AND, Compound 1 below, and Compound 2 below. 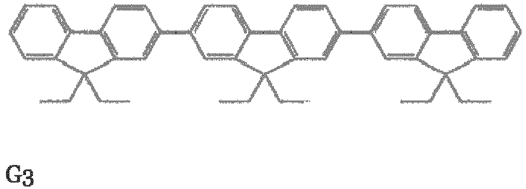 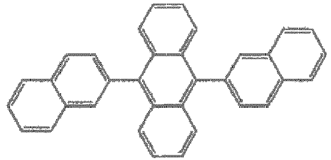 AND

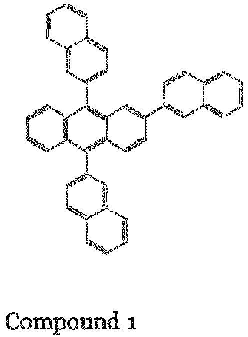

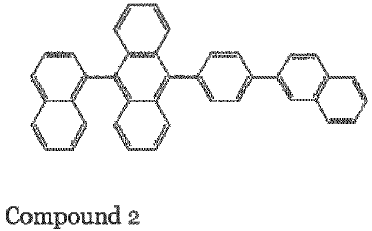

The emitter dopant may be a phosphorescent or fluorescent emitter. Phosphorescent emitters and emitters which emit light via a thermally activated delayed fluorescence (TADF) mechanism may be preferred due to their higher efficiency. The emitter may be a small molecule or a polymer.

Examples of red emitter dopants are PtOEP, Ir(piq)₃, and Btp₂lr(acac), but are not limited thereto. These compounds are phosphorescent emitters, however, fluorescent red emitter dopants could also be used.

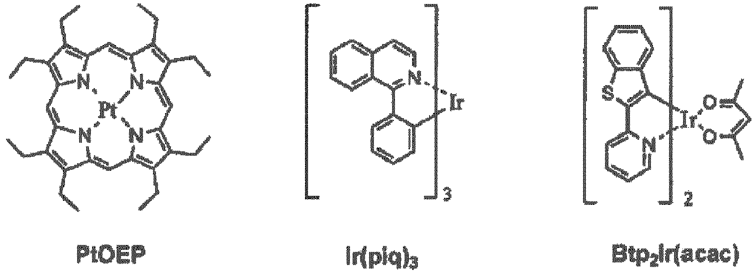

Examples of phosphorescent green emitter dopants are Ir(ppy)₃ (ppy = phenylpyridine), Ir(ppy)2(acac), Ir(mpyp)₃ are shown below. Compound 3 is an example of a fluorescent green emitter and the structure is shown below.

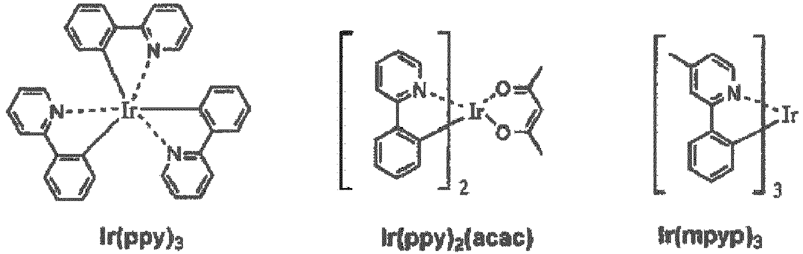

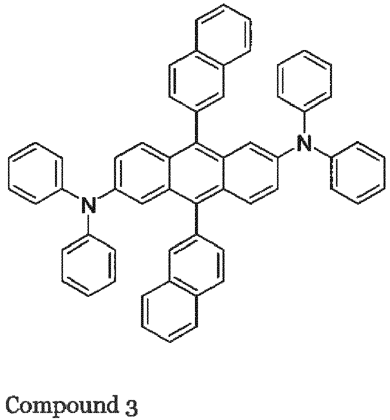

Examples of phosphorescent blue emitter dopants are F2Irpic, (F2ppy)2Ir(tmd) and Ir(dfppz)3, ter-fluorene, the structures are shown below. 4.4'-bis(4-diphenyl amiostyryl)biphenyl (DPAVBi), 2,5,8,11-tetra-tert-butyl perylene (TBPe), and Compound 4 below are examples of fluorescent blue emitter dopants.

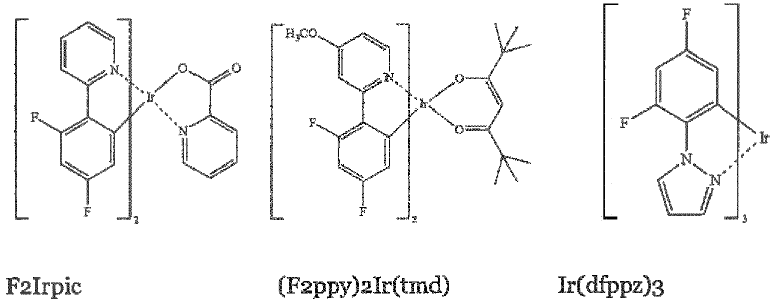

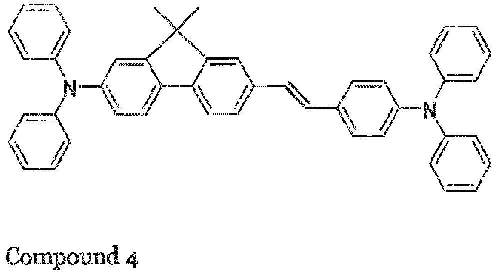

The amount of the emitter dopant may be in the range from about 0.01 to about 50 parts by weight, based on 100 parts by weight of the host. Alternatively, the emission layer may consist of a light-emitting polymer. The EML may have a thickness of about 10 nm to about 100 nm, for example, from about 20 nm to about 60 nm. When the thickness of the EML is within this range, the EML may have excellent light emission, without a substantial penalty in driving voltage.

### Hole blocking layer (HBL)

A hole blocking layer (HBL) may be formed on the EML, by using vacuum deposition, spin coating, slot-die coating, printing, casting, LB deposition, or the like, in order to prevent the diffusion of holes into the ETL. When the EML comprises a phosphorescent dopant, the HBL may have also a triplet exciton blocking function.

When the HBL is formed using vacuum deposition or spin coating, the conditions for deposition and coating may be similar to those for the formation of the HIL. However, the conditions for deposition and coating may vary, according to the compound that is used to form the HBL. Any compound that is commonly used to form a HBL may be used. Examples of compounds for forming the HBL include xadiazole derivatives, triazole derivatives, and phenanthroline derivatives.

The HBL may have a thickness in the range from about 5 nm to about 100 nm, for example, from about 10 nm to about 30 nm. When the thickness of the HBL is within this range, the HBL may have excellent hole-blocking properties, without a substantial penalty in driving voltage.

### Electron transport layer (ETL)

The OLED according to the present invention may contain an electron transport layer (ETL).

According to various embodiments the OLED may comprises an electron transport layer or an electron transport layer stack comprising at least a first electron transport layer and at least a second electron transport layer.

By suitably adjusting energy levels of particular layers of the ETL, the injection and transport of the electrons may be controlled, and the holes may be efficiently blocked. Thus, the OLED may have long lifetime.

The electron transport layer of the electronic device may comprise an organic electron transport matrix (ETM) material. Further, the electron transport layer may comprise one or more n-dopants. Suitable compounds for the ETM are not particularly limited. In one embodiment, the electron transport matrix compounds consist of covalently bound atoms. Preferably, the electron transport matrix compound comprises a conjugated system of at least 6, more preferably of at least 10 delocalized electrons. In one embodiment, the conjugated system of delocalized electrons may be comprised in aromatic or heteroaromatic structural moieties, as disclosed e.g. in documents EP 1 970 371 A1 or WO 2013/079217 A1.

### Electron injection layer (EIL)

The optional EIL, which may facilitates injection of electrons from the cathode, may be formed on the ETL, preferably directly on the electron transport layer. Examples of materials for forming the EIL include lithium 8-hydroxyquinolinolate (LiQ), LiF, NaCl, CsF, Li₂O, BaO, Ca, Ba, Yb, Mg which are known in the art. Deposition and coating conditions for forming the EIL are similar to those for formation of the HIL, although the deposition and coating conditions may vary, according to the material that is used to form the EIL.

The thickness of the EIL may be in the range from about 0.1 nm to about 10 nm, for example, in the range from about 0.5 nm to about 9 nm. When the thickness of the EIL is within this range, the EIL may have satisfactory electron-injecting properties, without a substantial penalty in driving voltage.

### Cathode electrode

The cathode electrode is formed on the EIL if present. The cathode electrode may be formed of a metal, an alloy, an electrically conductive compound, or a mixture thereof. The cathode electrode may have a low work function. For example, the cathode electrode may be formed of lithium (Li), magnesium (Mg), aluminum (Al), aluminum (Al)-lithium (Li), calcium (Ca), barium (Ba), ytterbium (Yb), magnesium (Mg)-indium (In), magnesium (Mg)-silver (Ag), or the like. Alternatively, the cathode electrode may be formed of a transparent conductive oxides, such as ITO or IZO.

The thickness of the cathode electrode may be in the range from about 5 nm to about 1000 nm, for example, in the range from about 10 nm to about 100 nm. When the thickness of the cathode electrode is in the range from about 5 nm to about 50 nm, the cathode electrode may be transparent or semitransparent even if formed from a metal or metal alloy.

It is to be understood that the cathode electrode is not part of an electron injection layer or the electron transport layer.

### Charge generation layer/hole generating layer

The charge generation layer (CGL) may be composed of a double layer.

Typically, the charge generation layer is a pn junction joining a n-type charge generation layer (electron generating layer) and a hole generating layer. The n-side of the pn junction generates electrons and injects them into the layer which is adjacent in the direction to the anode. Analogously, the p-side of the p-n junction generates holes and injects them into the layer which is adjacent in the direction to the cathode.

Charge generating layers are used in tandem devices, for example, in tandem OLEDs comprising, between two electrodes, two or more emission layers. In aa tandem OLED comprising two emission layers, the n-type charge generation layer provides electrons for the first light emission layer arranged near the anode, while the hole generating layer provides holes to the second light emission layer arranged between the first emission layer and the cathode.

In accordance with the invention, it may be provided that the electronic device comprises a hole injection layer as well as a hole generating layer. If the hole injection layer consists of the bismuth carboxylate complex, it is not obligatory that also the hole generating layer consists of the bismuth carboxylate complex. In such a case, the hole generating layer can be composed of an organic matrix material doped with p-type dopant. Suitable matrix materials for the hole generating layer may be materials conventionally used as hole injection and/or hole transport matrix materials. Also, p-type dopant used for the hole generating layer can employ conventional materials. For example, the p-type dopant can be one selected from a group consisting of tetrafluore-7,7,8,8-tetracyanoquinodimethane (F4-TCNQ), derivatives of tetracyanoquinodimethane, radialene derivatives, iodine, FeCl₃, FeF₃, and SbCl₅. Also, the host can be one selected from a group consisting of N,N'-di(naphthalen-1-yl)-N,N-diphenyl-benzidine (NPB), N,N'-diphenyl-N,N'-bis(3-methylphenyl)-i,i-biphenyl-1,1'-diamine (TPD) and N,N',N'-tetranaphthyl-benzidine (TNB).

In a preferred embodiment, the hole generating layer consists of the compound of formula (I).

The n-type charge generation layer can be layer of a neat n-dopant, for example of an electropositive metal, or can cosist of an organic matrix material doped with the n-dopant. In one embodiment, the n-type dopant can be alkali metal, alkali metal compound, alkaline earth metal, or alkaline earth metal compound. In another embodiment, the metal can be one selected from a group consisting of Li, Na, K, Rb, Cs, Mg, Ca, Sr, Ba, La, Ce, Sm, Eu, Tb, Dy, and Yb. More specifically, the n-type dopant can be one selected from a group consisting of Cs, K, Rb, Mg, Na, Ca, Sr, Eu and Yb.Suitable matrix materials for the electron generating layer may be the materials conventionally used as matrix materials for electron injection or electron transport layers. The matrix material can be for example one selected from a group consisting oftriazine compounds, hydroxyquinoline derivatives like tris(8-hydroxyquinoline)aluminum, benzazole derivatives, and silole derivatives.

in one embodiment, the n-type charge generation layer may include compounds of the following Chemical Formula X. 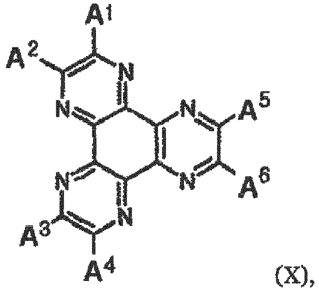 wherein each of A1 to A6 may be hydrogen, a halogen atom, nitrile (-CN), nitro (-NO2), sulfonyl (-SO2R), sulfoxide (-SOR), sulfonamide (-SO2NR), sulfonate (-SO3R), trifluoromethyl (-CF3), ester (-COOR), amide (-CONHR or - CONRR'), substituted or unsubstituted straight-chain or branched-chain C1-C12 alkoxy, substituted or unsubstituted straight-chain or branched-chain C1-C12 alkyl, substituted or unsubstituted straight-chain or branched chain C2-C12 alkenyl, a substituted or unsubstituted aromatic or non-aromatic heteroring, substituted or unsubstituted aryl, substituted or unsubstituted mono- or di-arylamine, substituted or unsubstituted aralkylamine, or the like. Herein, each of the above R and R' may be substituted or unsubstituted C1-C60 alkyl, substituted or unsubstituted aryl, or a substituted or unsubstituted 5- to 7-membered heteroring, or the like.

An example of such n-type charge generation layer may be a layer comprising CNHAT

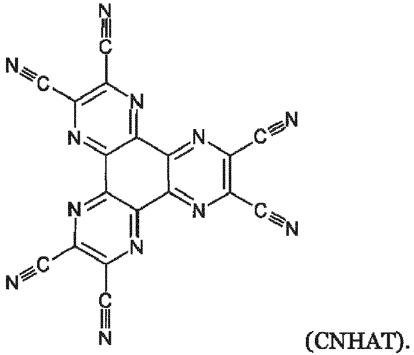

The hole generating layer is arranged on top of the n-type charge generation layer.

### Organic light-emitting diode (OLED)

According to one aspect of the present invention, there is provided an organic light-emitting diode (OLED) comprising: a substrate; an anode electrode formed on the substrate; a hole injection layer, a hole transport layer, an emission layer, and a cathode electrode.

According to another aspect of the present invention, there is provided an OLED comprising: a substrate; an anode electrode formed on the substrate; a hole injection layer, a hole transport layer, an electron blocking layer, an emission layer, a hole blocking layer and a cathode electrode.

According to another aspect of the present invention, there is provided an OLED comprising: a substrate; an anode electrode formed on the substrate; a hole injection layer, a hole transport layer, an electron blocking layer, an emission layer, a hole blocking layer, an electron transport layer, and a cathode electrode.

According to another aspect of the present invention, there is provided an OLED comprising: a substrate; an anode electrode formed on the substrate; a hole injection layer, a hole transport layer, an electron blocking layer, an emission layer, a hole blocking layer, an electron transport layer, an electron injection layer, and a cathode electrode.

According to various embodiments of the present invention, there may be provided OLEDs layers arranged between the above mentioned layers, on the substrate or on the top electrode.

According to one aspect, the OLED can comprise a layer structure of a substrate that is adjacent arranged to an anode electrode, the anode electrode is adjacent arranged to a first hole injection layer, the first hole injection layer is adjacent arranged to a first hole transport layer, the first hole transport layer is adjacent arranged to a first electron blocking layer, the first electron blocking layer is adjacent arranged to a first emission layer, the first emission layer is adjacent arranged to a first electron transport layer, the first electron transport layer is adjacent arranged to an n-type charge generation layer, the n-type charge generation layer is adjacent arranged to a hole generating layer, the hole generating layer is adjacent arranged to a second hole transport layer, the second hole transport layer is adjacent arranged to a second electron blocking layer, the second electron blocking layer is adjacent arranged to a second emission layer, between the second emission layer and the cathode electrode an optional electron transport layer and/or an optional injection layer are arranged.

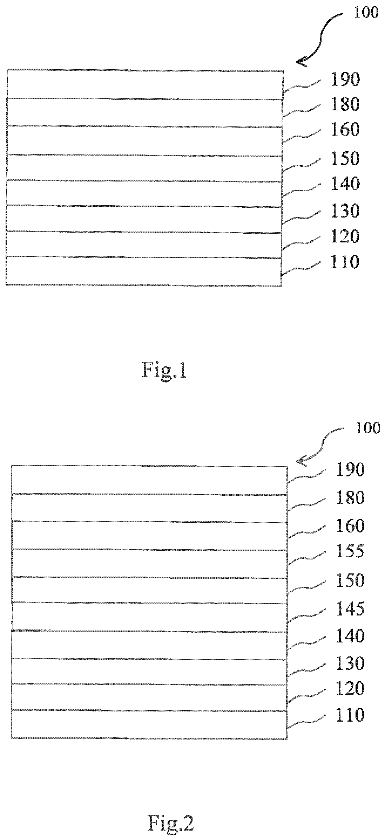

For example, the OLED according to Fig. 2 may be formed by a process, wherein
on a substrate (110), an anode (120), a hole injection layer (130), a hole transport layer (140), an electron blocking layer (145), an emission layer (150), a hole blocking layer (155), an electron transport layer (160), an electron injection layer (180) and the cathode electrode (190) are subsequently formed in that order.

### Details and definitions of the invention

The present invention is related to an electronic device. The device comprises a first electrode and a second electrode. Between the first electrode and the second electrode, at least one hole injection layer and/or at least one hole generating layer is arranged. That is, the electronic device may only comprise a hole injection layer between the first electrode and the second electrode. Likewise, the inventive electronic device may only comprise the hole generating layer between the first electrode and the second electrode. Likewise, the electronic device may comprise both the hole injection layer and the hole generating layer both between the first electrode and the second electrode. In case that electronic device only comprises the hole injection layer (and not the hole generating layer) it is provided that the hole injection layer consists of the bismuth carboxylate complex. Likewise, in the case that the electronic device comprises only the hole generating layer (and not the hole injection layer) it is provided that the hole generating layer consists of the bismuth carboxylate complex. In case that the electronic device comprises both the hole injection layer and the hole generating layer, it may be provided that only the hole injection layer consists of the bismuth carboxylate complex, that only the hole generating layer consists of the bismuth carboxylate complex or that both the hole injection layer and the hole generating layer consist of the bismuth carboxylate complex.

The term "consisting of" as used herein with respect to the hole injection layer and/or charge generating layer consisting of the bismuth carboxylate complex shall be understood in a way that only the bismuth carboxylate complex is used for preparing said layer. However, the term "consisting of" does not exclude the presence of minor impurities which cannot be avoided by appropriate technical means. Furthermore, the term " consisting of" does not exclude by-products which may directly be traced back to the bismuth carboxylate complex and which may be formed during formation of the hole injection layer using the neat bismuth carboxylate complex using common techniques known in the art, such as vacuum sublimation. In particular, the term "consisting of' as used in this regard does not exclude the presence of decomposition products or isomers of the bismuth carboxylate complex formed during formation of the hole injection layer.

A bismuth carboxylate complex in terms of the present invention comprises at least one bismuth ion or atom and at least one carboxylate group attached to the bismuth ion. A carboxylate group is an organic structural moiety having the general formula R-COO⁻(R may be R¹, R² and R³ as defined above).

In terms of the present invention, the bismuth carboxylate complex is electrically neutral if the (positive) charge of the bismuth ion is balanced by the negative charge of attached ligands, including the carboxylate compound.

In terms of the invention, the bismuth carboxylate complex is mononuclear if it comprises only one bismuth atom or ion.

The group R in the carboxylate anion may be a substituted or unsubstituted organic group, such as an alkyl group, an aryl group, an alkylaryl group etc.

The carboxylate anion is deemed to be partially fluorinated if at least one of the hydrogen atoms of the carboxylate anion comprised in the moiety R is substituted by a fluorine atom. A carboxylate anion is deemed to be fully fluorinated if all of the hydrogen atoms thereof are substituted by fluorine atoms. In general, the group R (respectively the group R¹, R² and R³) above may be carbon-containing group.

The term "carbon-containing group" as used herein shall be understood to encompass any organic group comprising carbon atoms, in particular organic groups, such as alkyl, aryl, heteroaryl, heteroalkyl, in particular such groups which are substituents usual in organic electronics, especially hydrocarbyl, cyano, heteroaryl etc..

The term "alkyl" as used herein shall encompass linear as well as branched and cyclic alkyl. For example, C₃-alkyl may be selected from n-propyl and iso-propyl. Likewise, C₄-alkyl encompasses n-butyl, sec-butyl and t-butyl. Likewise, C₆-alkyl encompasses n-hexyl and cyclo-hexyl.

The subscribed number n in Cₙ relates to the total number of carbon atoms in the respective alkyl, arylene, heteroarylene or aryl group.

The term "aryl" as used herein shall encompass phenyl (C₆-aryl), fused aromatics, such as naphthalene, anthracene, phenanthracene, tetracene etc. Further encompassed are biphenyl and oligo- or polyphenyls, such as terphenyl etc. Further encompassed shall be any further aromatic hydrocarbon substituents, such as fluorenyl etc. Arylene, respectively heteroarylene refers to groups to which two further moieties are attached.

The term "heteroaryl" as used herein refers to aryl groups in which at least one carbon atom is substituted by a heteroatom, preferably selected from N, O, S, B or Si.

The subscripted number n in Cₙ-heteroaryl merely refers to the number of carbon atoms excluding the number of heteroatoms. In this context, it is clear that a C₃ heteroarylene group is an aromatic compound comprising three carbon atoms, such as pyrazol, imidazole, oxazole, thiazole and the like.

In terms of the invention, the expression "between" with respect to one layer being between two other layers does not exclude the presence of further layers which may be arranged between the one layer and one of the two other layers. In terms of the invention, the expression "in direct contact" with respect to two layers being in direct contact with each other means that no further layer is arranged between those two layers. One layer deposited on the top of another layer is deemed to be in direct contact with this layer.

With respect to the inventive organic semiconductive layer as well as with respect to the inventive compound, the compounds mentioned in the experimental part are most preferred.

The inventive electronic device may be an organic electroluminescent device (OLED) an organic photovoltaic device (OPV) or an organic field-effect transistor (OFET).

According to another aspect, the organic electroluminescent device according to the present invention may comprise more than one emission layer, preferably two or three emission layers. An OLED comprising more than one emission layer is also described as a tandem OLED or stacked OLED.

The organic electroluminescent device (OLED) may be a bottom- or top-emission device.

Another aspect is directed to a device comprising at least one organic electroluminescent device (OLED). A device comprising organic light-emitting diodes is for example a display or a lighting panel.

In the present invention, the following defined terms, these definitions shall be applied, unless a different definition is given in the claims or elsewhere in this specification.

In the context of the present specification the term "different" or "differs" in connection with the matrix material means that the matrix material differs in their structural formula.

The energy levels of the highest occupied molecular orbital, also named HOMO, and of the lowest unoccupied molecular orbital, also named LUMO, are measured in electron volt (eV).

The terms "OLED" and "organic light-emitting diode" are simultaneously used and have the same meaning. The term "organic electroluminescent device" as used herein may comprise both organic light emitting diodes as well as organic light emitting transistors (OLETs).

As used herein, "weight percent", "wt.-%", "percent by weight", "% by weight", and variations thereof refer to a composition, component, substance or agent as the weight of that component, substance or agent of the respective electron transport layer divided by the total weight of the respective electron transport layer thereof and multiplied by 100. It is under-stood that the total weight percent amount of all components, substances and agents of the respective electron transport layer and electron injection layer are selected such that it does not exceed 100 wt.-%.

As used herein, "volume percent", "vol.-%", "percent by volume", "% by volume", and variations thereof refer to a composition, component, substance or agent as the volume of that component, substance or agent of the respective electron transport layer divided by the total volume of the respective electron transport layer thereof and multiplied by 100. It is understood that the total volume percent amount of all components, substances and agents of the cathode layer are selected such that it does not exceed 100 vol.-%.

All numeric values are herein assumed to be modified by the term "about", whether or not explicitly indicated. As used herein, the term "about" refers to variation in the numerical quantity that can occur. Whether or not modified by the term "about" the claims include equivalents to the quantities.

It should be noted that, as used in this specification and the appended claims, the singular forms "a", "an", and "the" include plural referents unless the content clearly dictates otherwise.

The term "free of', "does not contain", "does not comprise" does not exclude impurities. Impurities have no technical effect with respect to the object achieved by the present invention.

### BRIEF DESCRIPTION OF THE DRAWINGS

These and/or other aspects and advantages of the present invention will become apparent and more readily appreciated from the following description of the exemplary embodiments, taken in conjunction with the accompanying drawings, of which:
FIG. 1 is a schematic sectional view of an organic light-emitting diode (OLED), according to an exemplary embodiment of the present invention;
FIG. 2 is a schematic sectional view of an OLED, according to an exemplary embodiment of the present invention.
FIG. 3 is a schematic sectional view of a tandem OLED comprising a charge generation layer, according to an exemplary embodiment of the present invention.
FIG. 4 shows IV-curves in a blue OLED according to Example 1.
FIG. 5 shows IV-curves in a blue tandem OLED according to Example 2.

### DETAILED DESCRIPTION

Reference will now be made in detail to the exemplary embodiments of the present invention, examples of which are illustrated in the accompanying drawings, wherein like reference numerals refer to the like elements throughout. The exemplary embodiments are described below, in order to explain the aspects of the present invention, by referring to the figures.

Herein, when a first element is referred to as being formed or disposed "on" a second element, the first element can be disposed directly on the second element, or one or more other elements may be disposed there between. When a first element is referred to as being formed or disposed "directly on" a second element, no other elements are disposed there between.

FIG. 1 is a schematic sectional view of an organic light-emitting diode (OLED) 100, according to an exemplary embodiment of the present invention. The OLED 100 includes a substrate 110, an anode 120, a hole injection layer (HIL) 130, a hole transport layer (HTL) 140, an emission layer (EML) 150, an electron transport layer (ETL) 160. The electron transport layer (ETL) 160 is formed directly on the EML 150. Onto the electron transport layer (ETL) 160, an electron injection layer (EIL) 180 is disposed. The cathode 190 is disposed directly onto the electron injection layer (EIL) 180.

Instead of a single electron transport layer 160, optionally an electron transport layer stack (ETL) can be used.

Fig. 2 is a schematic sectional view of an OLED 100, according to another exemplary embodiment of the present invention. Fig. 2 differs from Fig. 1 in that the OLED 100 of Fig. 2 comprises an electron blocking layer (EBL) 145 and a hole blocking layer (HBL) 155.

Referring to Fig. 2, the OLED 100 includes a substrate 110, an anode 120, a hole injection layer (HIL) 130, a hole transport layer (HTL) 140, an electron blocking layer (EBL) 145, an emission layer (EML) 150, a hole blocking layer (HBL) 155, an electron transport layer (ETL) 160, an electron injection layer (EIL) 180 and a cathode electrode 190.

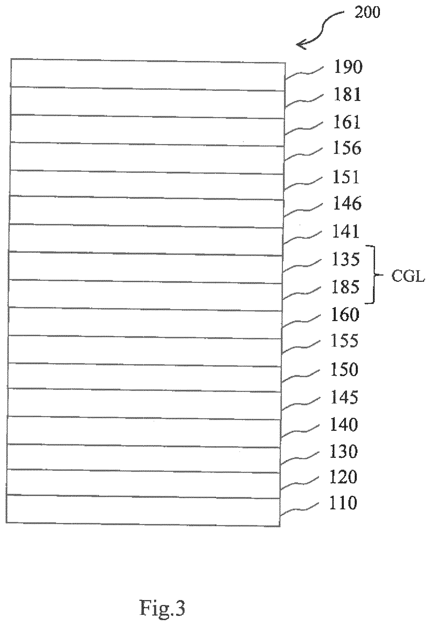

Fig. 3 is a schematic sectional view of a tandem OLED 200, according to another exemplary embodiment of the present invention. Fig. 3 differs from Fig. 2 in that the OLED 100 of Fig. 3 further comprises a charge generation layer and a second emission layer.

Referring to Fig. 3, the OLED 200 includes a substrate 110, an anode 120, a first hole injection layer (HIL) 130, a first hole transport layer (HTL) 140, a first electron blocking layer (EBL) 145, a first emission layer (EML) 150, a first hole blocking layer (HBL) 155, a first electron transport layer (ETL) 160, an n-type charge generation layer (n-type CGL) 185, a hole generating layer (p-type charge generation layer; p-type GCL) 135, a second hole transport layer (HTL) 141, a second electron blocking layer (EBL) 146, a second emission layer (EML) 151, a second hole blocking layer (EBL) 156, a second electron transport layer (ETL) 161, a second electron injection layer (EIL) 181 and a cathode 190.

While not shown in Fig. 1, Fig. 2 and Fig. 3, a sealing layer may further be formed on the cathode electrodes 190, in order to seal the OLEDs 100 and 200. In addition, various other modifications may be applied thereto.

Hereinafter, one or more exemplary embodiments of the present invention will be described in detail with, reference to the following examples. However, these examples are not intended to limit the purpose and scope of the one or more exemplary embodiments of the present invention.

### EXPERIMENTAL PART

### Generic procedures

OLEDs with two emitting layers were prepared to demonstrate the technical benefit of an organic electronic device comprising a hole injection layer and/or a hole generating layer according to the present invention. As proof-of-concept, the tandem OLEDs comprised two blue emitting layers.

A 15Ω /cm² glass substrate with 90 nm ITO (available from Corning Co.) was cut to a size of 150 mm x 150 mm x 0.7 mm, ultrasonically cleaned with isopropyl alcohol for 5 minutes and then with pure water for 5 minutes, and cleaned again with UV ozone for 30 minutes, to prepare a first electrode.

The organic layers are deposited sequentially on the ITO layer at 10⁻⁷ mbar, see Table 1 and 2 for compositions and layer thicknesses. In the Tables 1 to 3, c refers to the concentration, and d refers to the layer thickness.

Then, the cathode electrode layer is formed by evaporating aluminum at ultra-high vacuum of 10⁻⁷ mbar and deposing the aluminum layer directly on the organic semiconductor layer. A thermal single co-evaporation of one or several metals is performed with a rate of 0,1 to 10 nm/s (0.01 to 1 Å/s) in order to generate a homogeneous cathode electrode with a thickness of 5 to 1000 nm. The thickness of the cathode electrode layer is 100 nm.

The device is protected from ambient conditions by encapsulation of the device with a glass slide. Thereby, a cavity is formed, which comprises a getter material for further protection.

Current voltage measurements are performed at the temperature 20 °C using a Keithley 2400 source meter, and recorded in V.

### Experimental results

### Materials used in device experiments

The formulae of the supporting materials mentioned in both tables below are as follows: 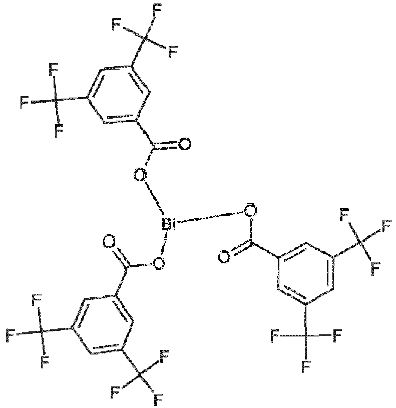
F1 is 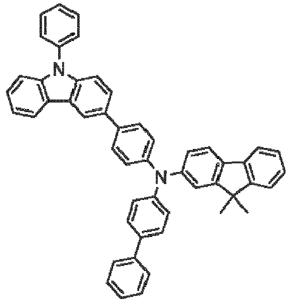 biphenyl-4-yl(9,9-diphenyl-9H-nuoren-2-yl)-[4-(9-phenyl-9H-carbazol-3-yl)phenyl]-amine, CAS 1242056-42-3;
F2 is 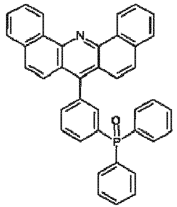 (published in EP 2 924 029), CAS 1440545-22-1;
F3 is 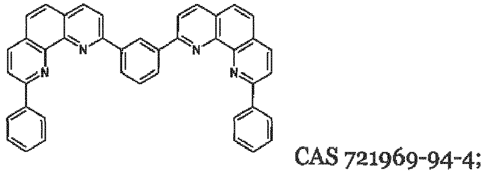 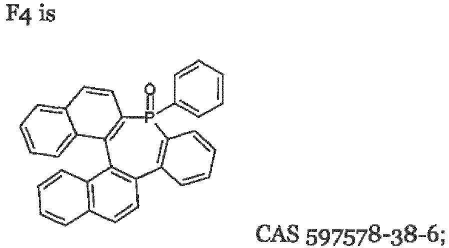
LiQ is lithium 8-hydroxyquinolinolate;
NUBD-370 and BD-200 are blue fluorescent emitter dopants and ABH-113 is a blue emitter host; all three materials are commercially available from SFC, Korea;
PD-2 is 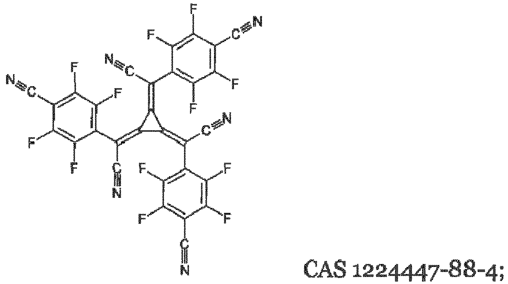 and
ZnPc is zinc phtalocyanine, CAS 14320-04-8.

The optional interlayer used in the exemplary tandem device can be made also of other materials usually utilized for this purpose, e.g. from other metal complexes, like the Zr complex having formula

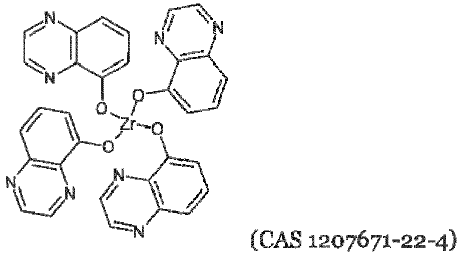

### Device stacks according to invention

### Example 1

Device comprising a bismuth carboxylate complex as a neat hole injection layer

**Tab. 1**

| Layer description | Material | c [vol%] | d [nm] |
|---|---|---|---|
| anode | ITO | 100 | 90 |
| hole injection layer (HIL) | neat B1 (inventive) vs B1:F1 (comparative) | 100 vs various concentratio ns | 10 |
| hole transport layer (HTL) | F1 | 100 | 120 |
| electron blocking layer (optional, not used in the model device of the example) | | | |
| emitting layer | ABH113: NUBD370 | 97:3 | 20 |
| hole blocking layer (optional, not used in the model device of the example) | | | |
| electron transport layer | F2: LiQ | 50:50 | 36 |
| cathode | Al | 100 | 100 |

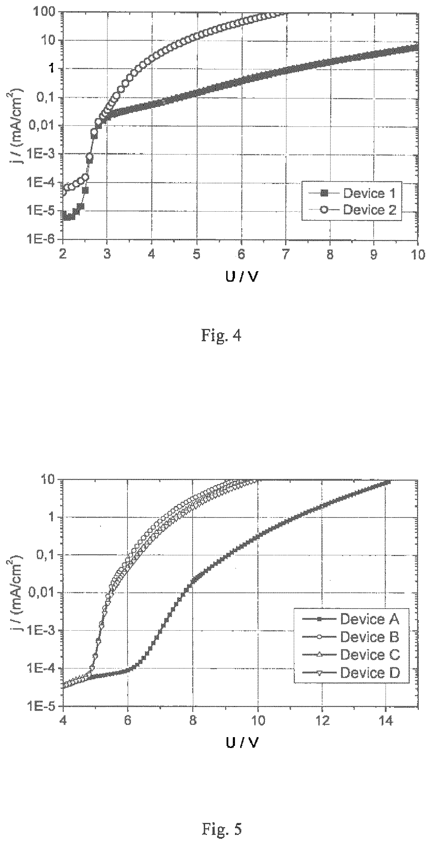

Two devices were prepared using the compounds, the amounts thereof and the layer thicknesses referred to in Table 1. In Device 1 (comparative) a hole injection layer was formed having a thickness of 10 nm F1:B1 (11.2 vol% Bi). In Device 2 (inventive) a 3 nm B1 (100 vol% B1) layer was used as the HIL. Experimental results achieved using the devices 1 and 2 are shown in FIG. 4.

### Example 2

Device comprising Bi carboxylate complex as a hole-generating part of a charge-generating layer

**Tab. 2**

| Layer description | Material | c [vol%] | d [nm] |
|---|---|---|---|
| anode | ITO | 100 | 90 |
| first hole injection layer | F1:PD-2 | 92:8 | 10 |
| first hole transport layer | F1 | 100 | 145 |
| first electron blocking layer (optional, not used in the model device of the example) | | | |
| first emitting layer | ABH113: BD200 | 97:3 | 20 |
| first electron transport layer | F2: LiQ | 50:50 | 25 |
| n-CGL | F3: Li | 99:1 | 10 |
| Interlayer (optional) | ZnPc | 100 | 2 |
| p-CGL | neat B1 (inventive) vs B1:F1 (comparative) | 100 vs various concentrations | 10 |
| second hole transport layer | F1 | 100 | 30 |
| second electron blocking layer (optional, not used in the model device of the example) | | | |
| second emitting layer | ABH113: BD200 | 97:3 | 20 |
| second electron transport layer | F2: LiQ | 50:50 | 26 |
| electron injection layer | F4: Yb | 95:5 | 10 |
| cathode | Al | 100 | 100 |

Four different devices were prepared using the materials, the amounts thereof and layer thicknesses disclosed in Table 2. In Device A (comparative) a 10 nm hole generating layer of F1:B1 (with 11.2 vol%, respectively 12.6 vol% of Bi) were prepared. The curves for both concentrations of the p-dopant were practically identical. Furthermore, inventive devices B, C and D have been prepared. In these devices, the hole generating layer (p-CGL) consisted of pure B1. The layer thickness was 3 nm (Device B), 5 nm (Device C) and 10 nm (Device D), respectively. Results achieved using the four devices are shown in FIG. 5.

The current-voltage characteristics given for the inventive and comparative devices in Figures 4 and 5 clearly show the surprising effect of the invention consisting in the fact that the inventive devices comprising a neat layer of the bismuth carboxylate complex reach the desired current density (and luminance) at a significantly lower operational voltages than the state-of-art device utilizing the same bismuth carboxylate complex as a dopant mixed with a hole transport matrix compound. The effect is quite insensitive to the thickness of the inventive neat layer of the bismuth carboxylate complex, as well as to the concentration of the bismuth carboxylate complex in the state-of-art doped layer.

The features disclosed in the foregoing description, in the claims and/or in the accompanying drawings may, both separately and in any combination thereof, be material for realizing the invention in diverse forms.

## Claims

1. Electronic device comprising, between a first electrode and a second electrode, at least one hole injection layer and/or at least one hole generating layer, wherein the hole injection layer and/or the hole generating layer consists of a bismuth carboxylate complex.

2. Electronic device according to claim 1, wherein the bismuth carboxylate complex is electrically neutral.

3. Electronic device according to claim 1 or 2, wherein the bismuth carboxylate complex is mononuclear.

4. Electronic device according to any of the preceding claims, wherein the bismuth in bismuth carboxylate complex is in the oxidation state +III.

5. Electronic device according to any of the preceding claims, wherein the bismuth carboxylate complex comprises a carboxylate anion which is partially or fully fluorinated and/or which comprises at least one nitrile group.

6. Electronic device according to any of the preceding claims, wherein the bismuth carboxylate complex comprises at least one carboxylate comprising at least one aromatic ring and/or at least one heteroaromatic ring.

7. Electronic device according to any of the preceding claims, wherein the bismuth carboxylate complex is represented by the following formula (I) 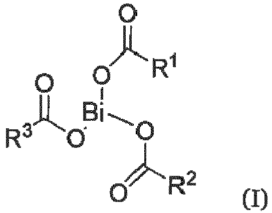 wherein R¹, R² and R³ are independently selected from a group comprising 1 to 40 carbon atoms, alternatively 2 to 30 carbon atoms, alternatively 3 to 20 carbon atoms, alternatively 4 to 16 carbon atoms, alternatively 5 to 12 carbon atoms, wherein
(i) each of the R¹, R², R³ may independently be substituted with one or more halogen atom(s) and/or one or more nitrile group(s) and/or
(ii) two or more of the groups R¹, R² and R³ may be linked with each other to form a ring.

8. Electronic device according to claim 7, wherein at least two of R¹, R² and R³ are the same, alternatively all of R¹, R² and R³ are the same.

9. Electronic device according to claim 7 or 8, wherein at least one of R¹, R² and R³ comprises at least one trifluoromethyl group.

10. Electronic device according to any of the claims 7 to 9, wherein at least one of R¹, R² and R³ is a phenyl group substituted with at least one trifluoromethyl group and/or substituted with at least one nitrile group.

11. Electronic device according to any of the preceding claims, wherein the bismuth carboxylate complex has the following chemical formula

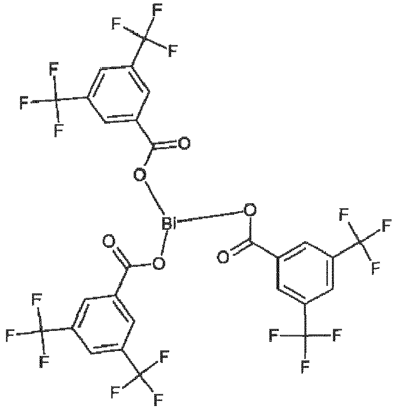

12. Electronic device according to any of the preceding claims, further comprising a hole transport layer, the hole transport layer being in direct contact with the hole injection and/or hole generating layer consisting of the bismuth carboxylate complex.

13. Method for preparing a device according to any of the preceding claims, comprising the steps of
(i) evaporating a bismuth carboxylate complex to form a vapor; and
(ii) depositing the vapor on a solid support to form the hole injection layer and/or the hole generating layer.

14. Method according to claim 13, wherein the solid support is a previously deposited layer, alternatively the anode, an electron generating layer, and/or an interlayer deposited on top of the electron generating layer.

15. Method according to claim 13, wherein the method comprises a further step (iii) of forming a hole transport layer on top of the hole injection layer and/or the hole generating layer formed in step (ii).
